# EUROPÄISCHE PATENTANMELDUNG

(11) **EP 2 111 089 A1**
(43) Veröffentlichungstag der Anmeldung: **21.10.2009**
(21) Anmeldenummer: 08007611.0
(22) Anmeldetag: 18.04.2008
(51) Int. Cl.: H05K 7/14

(54) **Frequenzumrichter**

(71) Anmelder: Grundfos Management A/S, 8850 Bjerringbro (DK)
(72) Erfinder: Mønster, Peter, 8900 Randers (DK); Friborg Thiesen, Martin, 8850 Bjerringbro (DK)
(74) Vertreter: Vollmann, Heiko

(57) **Zusammenfassung**

Der Frequenzumrichter (6) weist ein Gehäuse (7,8) auf, das zur Montage auf einem Elektromotor (1) ausgebildet und bestimmt ist und an einer Seite durch einen Deckel (8) abgeschlossen ist. Innerhalb des Gehäuses (7,8) ist mindestens eine bodenseitig angeordnete und dort befestigte Platine (11,12) vorgesehen. Weiterhin ist in einer anderen Ebene eine Platine (20) angeordnet, wobei die bodenseitige Platine (11) mit der Platine (20) über eine Steckverbindung verbunden ist. Die Platine (20) ist kraftschlüssig zwischen der bodenseitigen Platine (11) und dem das Gehäuse (7) abschließenden Gehäusedeckel (8) eingespannt.

## Beschreibung

Die Erfindung betrifft einen Frequenzumrichter mit den im Oberbegriff des Anspruchs 1 angegebenen Merkmalen.

Es zählt heutzutage zum Stand der Technik, einen Frequenzumrichter bzw. Frequenzumformer, wie er bei modernen Motoren zur Steuerung der Drehzahl, insbesondere zur Erzielung von Drehzahlen jenseits der durch die Netzfrequenz physikalisch bedingten Drehzahl eingesetzt wird, in einem Gehäuse anzuordnen, das zur Montage auf einem Elektromotor ausgebildet und bestimmt ist, so dass Frequenzumrichter und Motor fest miteinander verkabelt und zusammen gehandhabt und eingebaut werden können. Das Frequenzumrichtergehäuse ist nach Art eines vergrößerten Klemmenkastens gestaltet und umfasst typischerweise zum einen die Steuer- und Regelelektronik, zum anderen den eigentlichen Frequenzumrichter bestehend aus Eingangskreis, Zwischenkreis und Leistungskreis sowie die Anschlussklemmen für den Netzanschluss. Innerhalb des Frequenzumrichtergehäuses ist zumindest der Leistungskreis von der übrigen Elektronik getrennt angeordnet.

Da Länge und Breite des Frequenzumrichtergehäuses sich zumindest in etwa an den Motorabmessungen orientieren müssen und ein Überstand nur bedingt zulässig ist, zählt es zum Stand der Technik, innerhalb des Frequenzumrichtergehäuses zwei oder auch mehr Platinen mit den darauf ein- oder ggf. beidseitig angeordneten Bauteilen übereinander anzuordnen. Da der Motor, auf dem das Frequenzumrichtergehäuse angeordnet ist, im Betrieb mechanische Schwingungen erzeugt, ist es für die Zuverlässigkeit der innerhalb des auf dem Motor angeordneten Gehäuses befindlichen Frequenzumrichterelektronik wichtig, die Platinen innerhalb des Gehäuses in geeigneter Weise zu befestigen. Es zählt hierbei zum Stand der Technik, zwei oder mehr Platinen übereinander anzuordnen und über Abstandshülsen und hindurch geführte Schrauben fest mit dem Gehäuse zu verbinden. Der elektrische Verbund zwischen den Platinen wird dabei über elektrische Steckverbinder oder ggf. über Kabel und damit verbundene Stecker realisiert.

Ein solcher Aufbau ist nicht nur kompliziert und aufwändig, sondern hat auch im Falle von Reparaturen den Nachteil, dass beim Lösen der Schrauben alle übereinander angeordneten Platinen mit gelöst werden, was insbesondere den späteren Wiederzusammenbau erschwert. Darüber hinaus werden die vom Motor erzeugten mechanischen Schwingungen auf alle mit dem Gehäuse verbundenen Platinen und die darauf befindlichen Bauteile übertragen. Insbesondere bei den Steckverbindungen kann daher Schwingungsreibverschleiß (fretting corrosion) auftreten, der die elektrische Verbindung stört oder gar zerstört.

Vor diesem Hintergrund liegt der vorliegenden Erfindung die Aufgabe zugrunde, einen gattungsgemäßen Frequenzumrichter so auszubilden, dass das vorgenannte Problem nicht oder zumindest vermindert auftritt und er im Übrigen einen einfachen, insbesondere servicefreundlichen Aufbau aufweist.

Diese Aufgabe wird bei einem gattungsgemäßen Frequenzumrichter durch die im kennzeichnenden Teil des Anspruchs 1 angegebenen Merkmale gelöst. Vorteilhafte Ausgestaltungen der Erfindung sind in den Unteransprüchen, der nachfolgenden Beschreibung und der Zeichnung angegeben.

Der erfindungsgemäße Frequenzumrichter weist ein Gehäuse auf, das zur Montage auf einem Elektromotor ausgebildet und bestimmt ist und das an einer Seite durch einen Deckel abgeschlossen ist. Typischerweise sitzt ein solches Gehäuse an einer Umfangsseite des Motors, es kann jedoch gemäß der Erfindung auch an einer Stirnseite angeordnet sein. Unter Deckel im Sinne der vorliegenden Erfindung ist auch eine Gehäusehälfte, typischerweise ein bezogen auf den Motor nach außen weisendes Gehäuseteil zu verstehen, welches den übrigen, fest mit Motor verbundenen bzw. zur Verbindung mit dem Motor bestimmten Gehäuseteil ganz oder teilweise abdeckt. Der erfindungsgemäße Frequenzumrichter weist mindestens eine bodenseitig des Gehäuses angeordnete und befestigte Platine und mindestens eine weitere, in einer anderen Ebene angeordnete Platine auf, wobei die bodenseitige und die mindestens eine weitere Platine durch mindestens eine Steckverbindung miteinander verbunden sind. Erfindungsgemäß ist die mindestens eine weitere Platine kraftschlüssig zwischen der bodenseitigen Platine und dem das Gehäuse abschließenden Gehäusedeckel eingespannt.

Grundgedanke der vorliegenden Erfindung ist es somit, bei Anordnung mehrerer Platinen übereinander innerhalb des Frequenzumrichtergehäuses nur noch die bodenseitig angeordnete Platine fest, beispielsweise durch Schrauben, mit dem Gehäuse zu verbinden und die eine oder mehrere darüber angeordnete Platinen, also die gegenüberliegend zur bodenseitig angeordneten Platine benachbarte Platine und gegebenenfalls weitere Platinen kraftschlüssig zwischen den Gehäusedeckel und der bodenseitigen Platine einzuspannen. Die Verbindung und Fixierung der Platinen zueinander folgt dabei durch Steckverbindungen, die vorteilhaft sowohl den mechanischen Kontakt zwischen den Platinen als auch die elektrischen Verbindungen der Platine bilden.

Das kraftschlüssige Einspannen einer oder mehrerer Platinen zwischen einer bodenseitigen Platine und dem Gehäusedeckel hat zum einen den Vorteil, dass nach Abnehmen des Deckels die darunter liegenden Platinen bis zur bodenseitigen Platine in der Regel ohne Werkzeug durch Lösen der Steckverbindungen einfach abgezogen werden können und in entsprechender Weise schnell und einfach wieder miteinander verbunden und in Einbaulage gebracht werden können. Darüber hinaus hat jedoch die Einspannung einer oder mehrerer Platinen zwischen der bodenseitigen Platine und dem Deckel den wesentlichen Vorteil, dass die Motorschwingungen gedämpft übertragen werden, so dass der Schwingungsreibungsverschleiß der elektrischen Steckverbindungen deutlich vermindert werden kann.

Um die Vorspannkraft zwischen Gehäusedeckel und der darunter liegenden Platine bzw. den darunter liegenden Platinen in geeigneter Weise aufbringen zu können, ist es zweckmäßig, zwischen Gehäusedeckel und einer darunter deckelseitig angeordneten Platine mindestens einen Stützkörper aus einem federelastischen Material vorzusehen. Dieses federelastische Material wird beim Aufsetzen des Deckels zusammengedrückt und damit vorgespannt. Zweckmäßigerweise handelt es sich dabei um ein flächiges Material, beispielsweise ein Elastomer, welches großflächig zwischen Gehäusedeckel und Platine aufliegt und die vom Deckel nach dessen Befestigung aufgebrachte Spannkraft möglichst gleichmäßig über die Fläche der Platine bzw. der darauf angeordneten elektrischen/elektronischen Bauteile verteilt.

Um einerseits den Deckel bzw. den oberen Gehäuseteil auf einfache Weise befestigen und ggf. wieder entfernen zu können, andererseits jedoch eine ausreichende Spannkraft aufzubringen, die einerseits die Dichtheit der Deckel-Gehäuseverbindung gewährleistet und andererseits die dazwischen kraftschlüssig angeordnete Platine oder Platinen mit ausreichender Kraft hält, zu gewährleisten, ist der Deckel vorteilhaft schraubbefestigt, wobei die Einspannkraft durch die Schraubbefestigung des Deckels aufgebracht ist. Es wird also beim Anschrauben des Deckels kontinuierlich die Einspannkraft erhöht, bis der Deckel seine bestimmungsgemäße Position am Gehäuse erreicht hat und ein weiteres Eindrehen der Befestigungsschrauben unmöglich wird.

Zweckmäßigerweise ist der oder sind die Stützkörper elektrisch isolierend ausgebildet, so dass beim Anliegen an Leiterbahnen, Kontakten, elektrischen oder elektronischen Bauteilen keine Kriechströme oder gar Kurzschlussströme entstehen können. Grundsätzlich ist gemäß der Erfindung eine bodenseitig befestigte Platine sowie mindestens eine weitere, typischerweise darüber liegende, also gegenüberliegend benachbarte Platine vorgesehen, welche zwischen Deckel und der bodenseitigen Platine eingespannt ist. Es können jedoch gemäß der Erfindung auch zwei oder mehr nebeneinander angeordnete bodenseitige Platinen und entsprechend darüber angeordnete weitere Platinen vorgesehen sein. Die elektrische und mechanische Verbindung übereinander angeordneter, also gegenüberliegend benachbarter Platinen erfolgt dabei zweckmäßigerweise über Steckverbindungen, und zwar vorzugsweise nur über Steckverbindungen, welche sowohl die elektrischen Verbindungen als auch die mechanischen Verbindungen zwischen den Platinen bilden. Die Verbindung gegenüberliegend benachbarter Platinen nur über Steckverbindungen hat sich überraschenderweise als besonders vorteilhaft erwiesen, und zwar sowohl hinsichtlich einer Verringerung des Schwingungsreibungsverschleißes als auch natürlich hinsichtlich Montage und Demontage.

Eine solche Steckverbindung wird typischerweise durch ein mechanisches Steckerbauteil gebildet, welches von einem Isolator umgeben ist, der die einander gegenüberliegend benachbarten Platinen zueinander abstützt und der innen liegend einen oder mehrere Kontakte aufweist, welche platinenseitig angeordnete Kontakte elektrisch miteinander verbinden. Dabei sind typischerweise platinenseitig Kontakte steckerartig ausgebildet und im Stützkörper die Kontakte in Form von Muffen. Die Anordnung kann jedoch ggf. auch umgekehrt erfolgen oder kontaktweise unterschiedlich.

Grundsätzlich ist die Anzahl der Steckverbindungen zwischen zwei gegenüberliegend benachbart angeordneten Platinen frei wählbar. Besonders vorteilhaft ist es jedoch, wenn mindestens drei gesonderte Steckverbindungen vorgesehen sind, d. h. drei Steckverbindungen mit je einem gesonderten Stützkörper, die vorteilhaft voneinander beabstandet und über die Fläche der Platinen derart verteilt sind, dass die Stützkräfte möglichst gleichmäßig aufgebracht werden und keine oder nur geringe Momentenbelastung auf die Platine entsteht. Es versteht sich, dass innerhalb einer Steckverbindung eine Vielzahl elektrischer Verbindungen vorgesehen sein können.

Die vorliegende Erfindung beschränkt sich nicht darauf, zwischen einer bodenseitigen Platine, die fest mit dem Frequenzumrichtergehäuse verbunden ist und dem Gehäusedeckel eine weitere Platine kraftschlüssig einzuspannen, sondern es können gemäß der Erfindung auch zwei oder ggf. mehr übereinander, d. h. jeweils benachbart gegenüberliegend angeordnete Platinen so festgelegt werden, wobei dann zweckmäßigerweise nur die bodenseitige Platine am Frequenzumrichtergehäuse starr, z. B. durch Schrauben befestigt ist.

Vorteilhaft ist zwischen gegenüberliegend benachbarten Platinen eine elektrisch isolierende Schicht angeordnet. Eine solche Schicht stellt eine zusätzliche Sicherheit gegen ungewollte Nebenschlüsse und dadurch bedingte Kriechströme oder Kurzschlüsse zwischen den Platinen dar. Sie bildet zudem bei geeigneter Auslegung auch ein weiteres Dämpfungsglied zwischen den Platinen.

Die Erfindung ist nachfolgend anhand eines in der Zeichnung dargestellten Ausführungsbeispiels näher erläutert. Es zeigen:
- Fig. 1: einen Elektromotor mit Frequenzumrichter in Explosionsdarstellung,
- Fig. 2: in perspektivischer Darstellung den motorseitigen unteren Teil des Frequenzumrichtergehäuses mit zwei bodenseitigen Platinen und Befestigungsschrauben,
- Fig. 3: die Bauteile gemäß Fig. 2 in Einbaulage,
- Fig. 4: in perspektivischer Darstellung eine elektrisch isolierende Abdeckung für die bodenseitigen Platinen,
- Fig. 5: in perspektivischer Darstellung eine die Steuer- und Regelelektronik aufweisende weitere Platine,
- Fig. 6: in perspektivischer Darstellung eine weitere elektrisch isolierende Abdeckung,
- Fig. 7: die Abdeckung gemäß Fig. 6 in perspektivischer Darstellung von der Unterseite,
- Fig.8: in perspektivischer Darstellung die Bauteile gemäß den Figuren 4, 5 und 6 in Einbaulage,
- Fig.9: den Gehäusedeckel in perspektivischer Darstellung von unten,

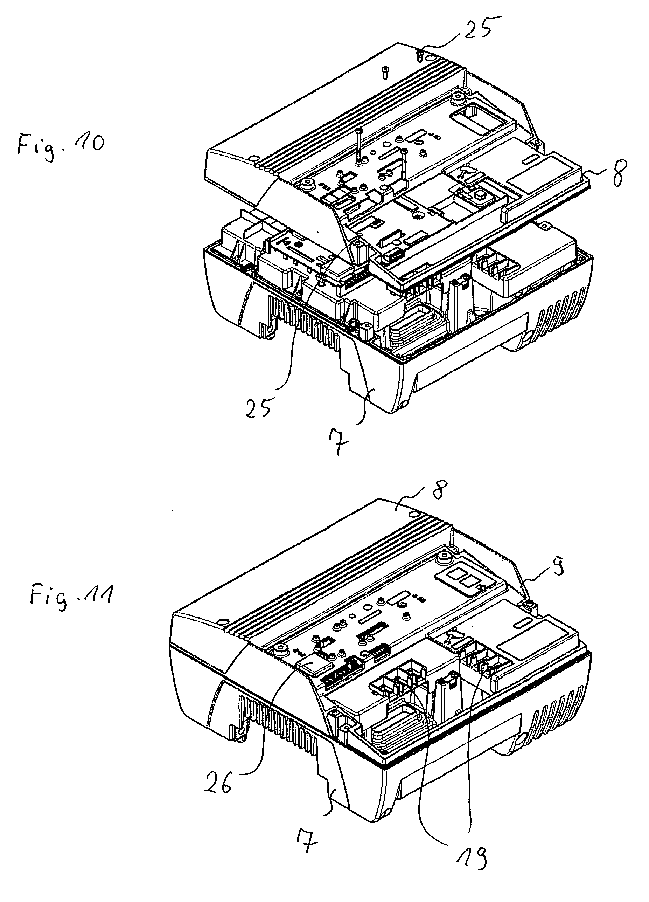

- Fig. 10: in perspektivischer Darstellung den Deckel gemäß Fig. 9 in Vormontageposition und
- Fig. 11: in perspektivischer Darstellung das Frequenzumrichtergehäuse mit montiertem Deckel und abgenommener Abdeckkappe.

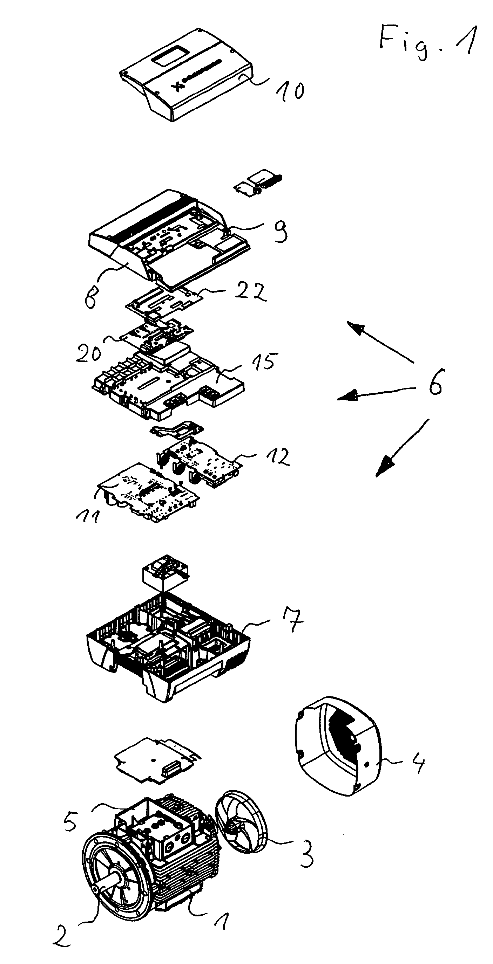

Die Explosionsdarstellung gemäß Fig. 1 zeigt den Gesamtaufbau des Aggregats mit einem Elektromotor 1 mit einer Antriebswelle 2, deren rückseitiges Ende ein Lüfterrad 3 trägt, welches von einer Lüfterhaube 4 abgedeckt wird, um so im Betrieb einen Luftstrom längs der mit Kühlrippen versehenen Umfangsfläche des Motors 1 parallel zur Längsachse zu erzeugen. Die Oberseite des Elektromotors ist mit einem kastenartigen Rahmen 5 versehen, der zur Befestigung und Aufnahme eines Frequenzumrichters 6 vorgesehen ist, der einen unteren Gehäuseteil 7 aufweist, der am Rahmen 5 befestigt ist und dessen oberer Gehäuseteil durch einen Deckel 8 gebildet ist, der wiederum eine obere Öffnung 9 aufweist, die mittels einer Abdeckkappe 10 verschließbar ist. Diese Öffnung 9 gibt Zugang zu einer Art Klemmenkasten. Durch sie sind die elektrischen Anschlüsse des Motors zugänglich, wenn die Abdeckkappe 10 entfernt ist.

Die Frequenzumrichterelektronik sowie die zugehörige Steuer- und Regelelektronik ist innerhalb des Gehäuses 7, 8 angeordnet. Im unteren Gehäuseteil 7 ist eine Leitungsdurchführung zur elektrischen Verbindung zwischen Frequenzumrichter 6 und Elektromotor 1 vorgesehen.

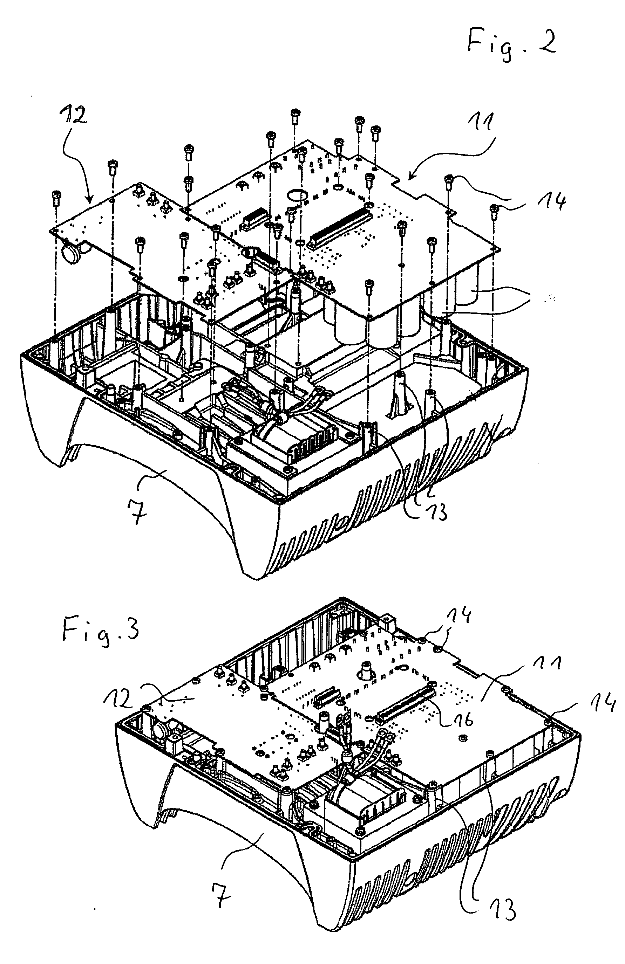

Der untere Gehäuseteil 7 des Frequenzumrichters 6 ist außenseitig an die Außenkontur des Elektromotors 1 angepasst. Die sich dadurch innen ergebende Topografie ist durch geeignete Anordnung der elektrischen/elektronischen Bauteile genutzt. So liegen die Wärme erzeugenden Leistungsbauteile nahe der Mitte des unteren Gehäuseteils 7, wo entsprechende Wärmeanschlussflächen vorgesehen sind, wohingegen groß bauende Bauteile wie Kondensatoren und Spulen im Seitenbereich angeordnet sind. Bodenseitig des Gehäuseteils 7 sind zwei Platinen 11 und 12 angeordnet, die auf bodenseitigen Stützen 13 aufliegen, in welche die Platinen 11, 12 durchsetzende Schrauben 14 eingreifen, mit denen die Platinen 11 und 12 fest mit dem unteren Gehäuseteil 7 verbunden sind. Die Platine 12 umfasst im Wesentlichen den Eingangskreis des Frequenzumrichters, d. h. den Gleichrichterkreis, wohingegen die Platine 11 den Zwischenkreis sowie den Leistungskreis umfasst. Die Platinen 11 und 12 sind die Topografie des unteren Gehäuseteils 7 ausnutzend im Wesentlichen hängend bestückt, d. h. die elektrischen/elektronischen Bauteile sind zum Gehäuseboden hin gerichtet, wo Wärmeanschlussflächen vorgesehen sind, über welche bei den Wärme erzeugenden Bauteilen die Abwärme über das Gehäuseteil 7 und insbesondere die dort nach unten vorgesehenen Kühlrippen abgeführt wird. In montiertem Zustand liegen die Platinen 11, 12 im Wesentlichen in einer Ebene, etwa in der Teilungsebene des Gehäuses zwischen unterem Gehäuseteil 7 und Deckel 8 (siehe Fig. 3).

Zwar sind auf den Platinen 11 und 12 in Einbaulage gemäß Fig. 3 auch auf der Oberseite noch elektrische und elektronische Bauteile vorgesehen, doch handelt es sich hier im Wesentlichen um Steckverbindungen zum Anschluss der weiter unten noch beschriebenen, darüber liegenden Elektronik.

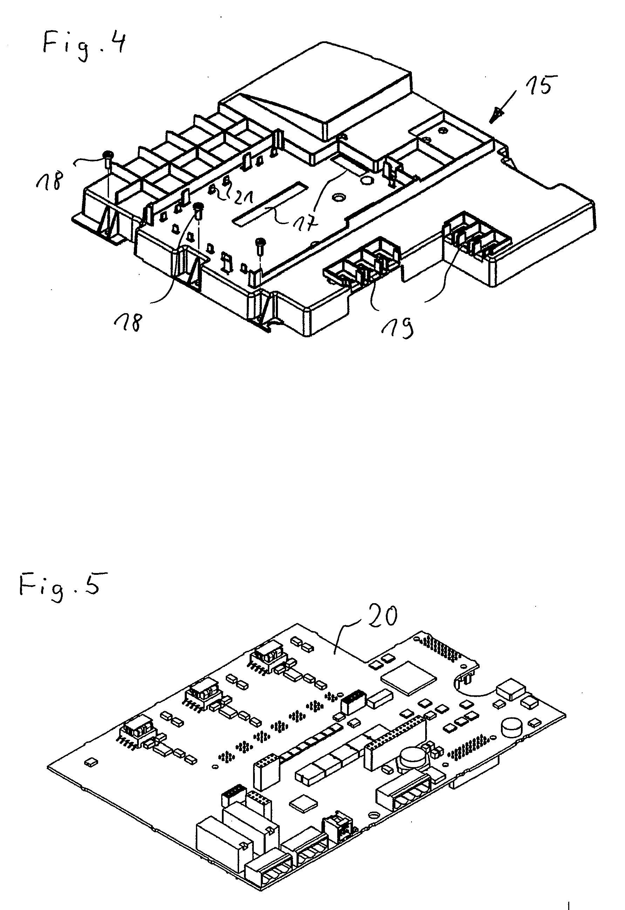

Nach oben hin abgedeckt werden die Platinen 11 und 12 durch eine elektrische Isolierung in Form eines Isolationskörpers 15, der im Bereich der Steckverbindungen 16 Ausnehmungen 17 aufweist und im Übrigen mittels Schrauben 18 mit dem Gehäuseteil 7 bzw. den darin befindlichen Platinen 11, 12 verbunden ist. Der Isolationskörper 15 weist im Übrigen dort Ausnehmungen auf, wo die späteren elektrischen Anschlüsse 19 vorgesehen sind, die durch die Abdeckkappe 10 überdeckt werden. Der Isolationskörper 15 ist an seiner Oberseite zur Aufnahme einer Platine 20 ausgebildet und weist hierzu Hilfsstützen 21 auf, die eine randseitige Auflage für die Platine 20 bilden. Die Platine 20, welche die Steuer- und Regelelektronik des Frequenzumrichters 6 trägt, weist an der in Fig. 5 nicht sichtbaren Unterseite einen zentralen Steckverbinder auf, der durch die Ausnehmung 17 greift und mit den Steckverbindungen 16 an der nach oben gerichteten Seite der Platine 11 kontaktiert. Der Steckverbinder ist so ausgestaltet, dass innenseitig die elektrischen Kontakte und Verbindungen gebildet sind, wohingegen die Außenseite einen elektrisch isolierenden Körper bildet, der zugleich eine mechanische Stütze bildet, welche die Platine 20 gegenüber der gehäusefesten Platine 11 abstützt. Die Platine 20 erstreckt sich in Einbaulage über der Platine 11, ist dieser also benachbart gegenüberliegend, jedoch in einer anderen Ebene angeordnet, während die neben der Platine 11 angeordnete Platine 12 letzterer lediglich benachbart ist und somit in derselben Ebene liegt.

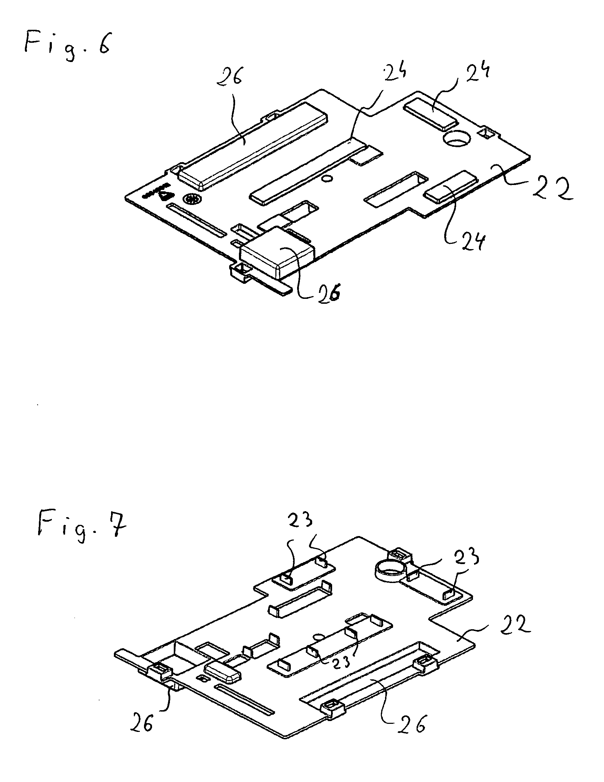

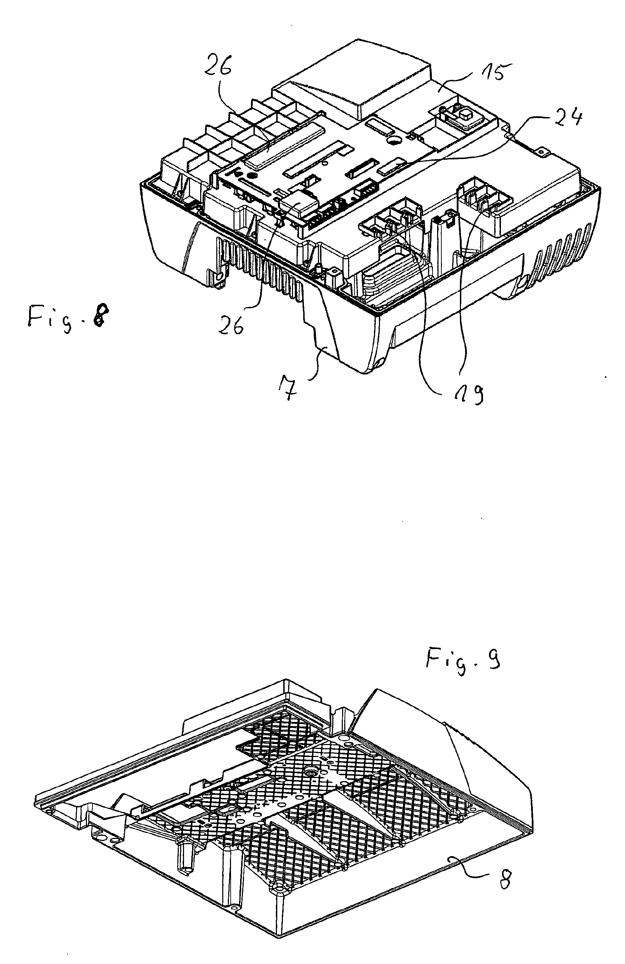

Die Platine 20 wird nach oben hin durch einen Isolations- und Stützkörper 22 abgedeckt, wie er in Fig. 6 dargestellt ist. Dieser Isolations- und Stützkörper 22 weist an seiner Unterseite Stützen 23 auf, welche zur Auflage auf der Platine 20 vorgesehen sind, und zwar an den Stellen, an welchen keine elektronischen oder elektrischen Bauteile vorgesehen sind. In Fig. 8 sind der untere Gehäuseteil 7 mit den darin befindlichen Platinen 11 und 12, dem darüber angeordneten Isolationskörper 15, der Platine 20 sowie dem darüber liegenden Isolations- und Stützkörper 22 in Einbaulage dargestellt.

Da die Platine 20 nur durch eine Steckverbindung fixiert und der Isolations- und Stützkörper 22 ebenfalls nur lose aufliegend angeordnet ist, muss zur endgültigen Befestigung dieser Bauteile der Deckel 8 montiert werden. Um einerseits Fertigungstoleranzen auszugleichen, andererseits die Platine 20 innerhalb des Frequenzumrichtergehäuses 7, 8 kraftschlüssig zu halten, ist auf dem Isolations- und Stützkörper 22 an der Oberseite in den Bereichen, in denen an der Unterseite die Stützen 13 angeordnet sind, elastisches Material 24 vorgesehen, dessen Höhe größer als der zwischen Deckel 8 und dem Isolations- und Stützkörper 22 gebildete Freiraum ist, sodass in montiertem Zustand eine Vorspannung auf den Isolations- und Stützkörper 22 und die darunter liegende Platine 20 erzeugt wird. Die Unterseite des Deckels ist, wie Fig. 9 zeigt, entsprechend strukturiert ausgebildet, um diese Kräfte ohne Verformung aufnehmen zu können und um den Isolations- und Stützkörper 22 in seiner eingespannten Stellung zu fixieren. Das elastische Material 24, das bei geschlossenem Gehäuse vorgespannt ist und somit die Platine 20 gegenüber der bodenseitigen Platine 11 und dem Deckel 8 verspannt, hat auch dämpfende Eigenschaften, wodurch die im Betrieb auf die Platine 20 ausgeübten Schwingungen vermindert werden. Durch Aufschrauben des Deckels 8 mittels Deckelschrauben 25, welche den Deckel 8 mit dem unteren Gehäuseteil 7 verbinden, wird das elastische Material 24 zusammen gepresst, so dass die Platine 20 kraftschlüssig, nämlich durch Vorspannung dieses Materials 24 schwingungsgedämpft und zugleich fest innerhalb des Frequenzumrichtergehäuses 7, 8 gehalten ist. Die verbleibende Öffnung 9 im Deckel 8 dient zum Anschluss des Motors, d. h. zum Zugänglichmachen der entsprechenden Anschlussklemmen und wird im Betrieb durch die in Fig. 1 sichtbare Abdeckkappe 10 verschlossen.

Weiterhin weist der isolations- und Stützkörper Ausnehmungen mit darüber liegenden Schutzkappen 26 auf, die zu Schutz von elektronischen, an der Oberseite der Platine 20 angeordneten Bauteilen dienen. Die Schutzkappen 26 sind vorgesehen, da sich diese elektronischen Bauteile nicht nur durch den Isolations- uns Stützkörper 22 sondern auch durch entsprechenden Ausnehmungen im Deckel 8 erstrecken. Die Schutzkappen 26 schützen somit diese elektronischen Bauteile nach oben hin, die sonst nach Abnehmen der Abdeckkappe 10 frei zugänglich wären und durch Abrutschen eines Werkzeugs oder ein sonstiges Missgeschick leicht beschädigt werden könnten.

### Bezugszeichenliste

- 1 -: Elektromotor
- 2 -: Welle
- 3 -: Lüfterrad
- 4 -: Lüfterhaube
- 5 -: Rahmen
- 6 -: Frequenzumrichter
- 7 -: unteres Gehäuseteil
- 8 -: Deckel (oberes Gehäuseteil)
- 9 -: Öffnung im Deckel
- 10 -: Abdeckkappe
- 11 -: Platine
- 12 -: Platine
- 13 -: Stützen
- 14 -: Schrauben
- 15 -: Isolationskörper
- 16 -: Steckverbindungen
- 17 -: Ausnehmungen
- 18 -: Schrauben
- 19 -: elektrische Anschlüsse
- 20 -: Platine
- 21 -: Hilfsstützen
- 22 -: Isolations- und Stützkörper
- 23 -: Stützen
- 24 -: elastisches Material
- 25 -: Deckelschrauben

## Patentansprüche

1. Frequenzumrichter mit einem Gehäuse (7), das zur Montage auf einem Elektromotor (1) ausgebildet und bestimmt und an einer Seite durch einen Deckel (8) abgeschlossen ist, mit mindestens einer bodenseitig des Gehäuses (7) angeordneten und befestigten Platine (11, 12) und mit mindestens einer weiteren in ein anderen Ebene angeordneten Platine (20), wobei die bodenseitige und die mindestens eine weitere Platine (11, 20) durch mindestens eine Steckverbindung (16) miteinander verbunden sind, **dadurch gekennzeichnet, dass** die mindestens eine weitere Platine (20) kraftschlüssig zwischen der bodenseitigen Platine (11) und dem das Gehäuse (7) abschließenden Gehäusedeckel (8) eingespannt ist.

2. Frequenzumrichter nach Anspruch 1, **dadurch gekennzeichnet, dass** zwischen Gehäusedeckel (8) und einer weiteren deckelseitig angeordneten Platine (20) mindestens ein Stützkörper aus einem federelastischem Material (24) vorgesehen ist.

3. Frequenzumrichter nach einem der vorhergehenden Ansprüche, **dadurch gekennzeichnet, dass** der Deckel (8) am Gehäuse (7) schraubbefestigt ist und dass die Einspannkraft durch die Schraubbefestigung des Deckels (8) aufgebracht ist.

4. Frequenzumrichter nach einem der vorhergehenden Ansprüche, **dadurch gekennzeichnet, dass** der Stützkörper elektrisch isolierend ausgebildet ist.

5. Frequenzumrichter nach einem der vorhergehenden Ansprüche, **dadurch gekennzeichnet, dass** zwei oder mehr bodenseitig angeordnete Platinen (11, 12) vorgesehen sind, denen über Steckverbindungen zwei oder mehr weitere deckelseitige Platinen (20) zugeordnet sind, wobei jede deckelseitige Platine (20) kraftschlüssig zwischen dem Gehäusedeckel (8) und mindestens einer bodenseitigen Platine (11, 12) eingespannt ist.

6. Frequenzumrichter nach einem der vorhergehenden Ansprüche, **dadurch gekennzeichnet, dass** gegenüberliegend benachbarte Platinen (11, 20) nur über Steckverbindungen (16) miteinander verbunden sind.

7. Frequenzumrichter nach einem der vorhergehenden Ansprüche, **dadurch gekennzeichnet, dass** eine Steckverbindung eine elektrische Verbindung aufweist, wobei die elektrischen Kontakte von einem Isolator umgeben sind, welcher die einander gegenüberliegend benachbarten Platinen (11, 20) zueinander abstützt.

8. Frequenzumrichter nach einem der vorhergehenden Ansprüche, **dadurch gekennzeichnet, dass** zwischen einer bodenseitigen und einer deckelseitigen Platine (11, 20) mindestens drei Steckverbindungen (16) vorgesehen sind.

9. Frequenzumrichter nach einem der vorhergehenden Ansprüche, **dadurch gekennzeichnet, dass** zwischen einer bodenseitigen und einer deckelseitigen Platine (11, 20) eine oder mehrere weitere Platinen über Steckverbindungen eingegliedert sind.

10. Frequenzumrichter nach einem der vorhergehenden Ansprüche, **dadurch gekennzeichnet, dass** zwischen gegenüberliegend benachbarten Platinen (11, 20) eine elektrisch isolierende Schicht (15) angeordnet ist.
